# EUROPEAN PATENT APPLICATION

(11) **EP 4 044 779 A1**
(43) Date of publication of application: **17.08.2022**
(21) Application number: 21157497.5
(22) Date of filing: 16.02.2021
(51) Int. Cl.: H05K 7/20, H01L 23/367, H01L 23/40, H01L 23/46

(54) **APPARATUS FOR COOLING**

(71) Applicant: Nokia Technologies Oy, 02610 Espoo (FI)
(72) Inventor: Ilmonen, Matias, 91900 Liminka (FI); Turula, Jussi Ilkka, 90310 Oulu (FI); Niskasaari, Veikko Olavi, 91800 Tyrnava (FI)
(74) Representative: Swindell & Pearson Limited

(57) **Abstract**

Examples of the disclosure relate to an apparatus for cooling. The apparatus comprises at least one heat source; at least part of a frame; cooling means configured to enable cooling of the at least one heat source; thermal interface material provided between the at least one heat source and at least part of the cooling means so as to provide a thermal interface between the at least one heat source and the cooling means; and fastening means configured to fasten the cooling means to the at least part of a frame; wherein, the fastening means are configured to bias at least part of the cooling means against the heat source to maintain the at least one cooling means in thermal contact with the heat source and to substantially minimize the thickness of the layer of thermal interface material between the at least one heat source and the cooling means.

## Description

### TECHNOLOGICAL FIELD

Examples of the disclosure relate to apparatus for cooling. Some relate to apparatus for cooling heat sources such as electronic components.

### BACKGROUND

Cooling systems are used to enable the function of devices, such as electronic devices, that generate unwanted heat during use. Increasing the efficiency of these systems can enable more heat to be transferred and improve the functioning of such devices.

### BRIEF SUMMARY

According to various, but not necessarily all, examples of the disclosure there is provided an apparatus comprising: at least one heat source; at least part of a frame; cooling means configured to enable cooling of the at least one heat source; thermal interface material provided between the at least one heat source and at least part of the cooling means so as to provide a thermal interface between the at least one heat source and the cooling means; and fastening means configured to fasten the cooling means to the at least part of a frame; wherein, the fastening means are configured to bias at least part of the cooling means against the heat source to maintain the at least one cooling means in thermal contact with the heat source and to substantially minimize the thickness of the layer of thermal interface material between the at least one heat source and the cooling means.

The at least one heat source may comprise one or more electronic components.

The at least one heat source may comprise a system on a chip.

The frame may be configured to provide structural rigidity to the cooling means.

The fastening means may be configured to bias at least part of the cooling means against the heat source to maintain the cooling means in thermal contact with the at least one heat source during use of the apparatus.

The fastening means may comprise any one or more of; spring screws, leaf springs.

The thermal interface material may be configured to provide a direct interface between the at least one heat source and the cooling means.

The thermal interface material may be provided to remove air gaps between the at least one heat source and the cooling means.

The thermal interface material may comprise a grease.

The apparatus may comprise a flexible seal provided around the edge of the apparatus.

The seal may be flexible to allow for vertical movement of the seal.

The seal may provide for ingress protection.

The cooling means may comprise one or more heat sinks.

The cooling means may be configured to enable heat from the heat source to be transferred to a coolant.

The cooling means may comprise a plurality of fins.

### BRIEF DESCRIPTION

Some examples will now be described with reference to the accompanying drawings in which:
FIG. 1 shows an example apparatus;
FIG. 2 shows an example apparatus;
FIG. 3 shows an example apparatus;
FIGS. 4A to 4C show an example apparatus;
FIG. 5 shows an example apparatus; and
FIG. 6 shows an example apparatus.

### DETAILED DESCRIPTION

Examples of the disclosure relate to an apparatus 101 comprising one or more heat sources that generate unwanted heat during use. Examples of the disclosure enable a good thermal interface to be provided between the one or more heat sources and a cooling means. The good thermal interface enables efficient cooling of the one or more heat sources and can improve the functioning of the heat sources.

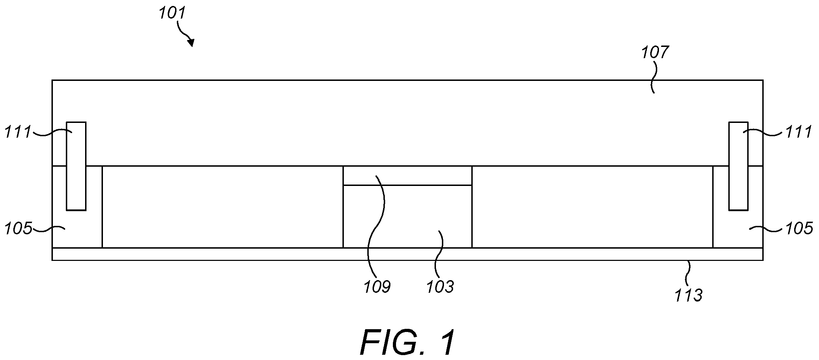

Fig. 1 schematically shows an example apparatus 101 according to examples of the disclosure.

The apparatus 101 comprises a heat source 103, a frame 105, cooling means 107, thermal interface material 109 and fastening means 111. It is to be appreciated that the apparatus 101 can also comprise other components that are not shown in Fig. 1. For example, the apparatus 101 could comprise a seal or any other suitable components.

The heat source 103 can comprise any components that generate unwanted heat during use. The heat source 103 can comprise one or more electronic components. In some examples the electronic components can comprise a system on a chip. The system on a chip could be configured to enable transmission and/or reception of wireless signals or for any other suitable function.

In the example of Fig. 1 the heat source 103 is provided on a printed circuit board (PCB) 113. Only one heat source 103 is shown in Fig. 1. It is to be appreciated that any number of heat sources 103 could be provided on the same PCB 113.

A frame 105 is provided around the heat source 103. The frame 105 can be provided around the edge of the PCB 113. The frame 105 can comprise one or more frame members. The frame members can be coupled together to form a rigid frame 105. The frame 105 can comprise any means that provides rigidity to components of the apparatus 101. The frame 105 can comprise a chassis or other means that can be provided around the apparatus 101 to create a mechanical support structure. In some examples the fram3 105 can be configured to provide structural rigidity to the cooling means 107 or any other suitable components of the apparatus 101.

The frame 105 can be formed from any suitable material. In some examples the frame 105 can be formed from a thermally conductive material such as a metal.

The cooling means 107 can comprise any means for enabling heat to be transferred away from the heat sources 103. The cooling means 107 can comprise one or more cooling components and/or cooling structures.

In some examples the cooling means 107 can comprise one or more heat sinks or any other suitable structures. In some examples the cooling means 107 can comprise a three-dimensional heat sink. The three-dimensional heat sink can comprise one or more structures that extends out of a flat, or substantially flat, surface. In some examples the cooling means 107 can comprise fins or other structures having a large surface area to enable the dissipation of heat.

The cooling means 107 can be configured to enable heat from the heat source to be transferred to a coolant. The coolant could be air or a liquid coolant. The coolant could be part of an auxiliary cooling system that enables heat to be transferred away from the apparatus 101.

The apparatus 101 also comprises a thermal interface material 109. The thermal interface material 109 can be provided between the heat source 103 and the cooling means 107. The thermal interface material 109 can provide a direct interface between the heat source 103 and the cooling means 107 so that there are no additional, intervening components between the heat source 103 and the cooling means 107.

The thermal interface material 109 can be provided to remove, or substantially remove, any air gaps between the heat source 103 and the cooling means 107. For example, the thermal interface material 109 can be provided to fill in scratches or other imperfections in the surfaces of the heat source 103 and the cooling means 107. The thermal interface material 109 therefore improves the thermal interface between the heat source 103 and the cooling means 107 by removing air gaps or other imperfections in the surfaces of the heat source 103 and the cooling means 107.

The thermal interface material 109 can comprise a grease or other suitable substance that can be spread on the surfaces of the heat sources 103 and the cooling means 107. In some examples the thermal interface material 109 can comprise a silicone based grease or any other suitable type of material.

The thermal interface material 109 can be provided in a thin layer. The thermal interface material 109 can be provided in a layer that is much thinner than the thickness of the heat source 103 or the frame 105. In some examples of the disclosure the thermal interface material 109 can be provided in a layer that is less than a micrometer thick.

The apparatus 101 also comprises fastening means 111. The fastening means 111 can comprise one or more fasteners. The fastening means 111 can comprise any means that can be configured to fasten the cooling means 107 to at least part of the frame 105. For example, the fastening means 111 can be used to fasten the cooling means 107 to one or more frame members of the frame 105. The fastening means 111 can comprise any means that secures the cooling means 107, or at least part of the cooling means 107 to the frame 105. The fastening means 111 can be configured to prevent movement of the cooling means 107 relative to the frame 105. The fastening means 111 can be configured to prevent movement of the cooling means 107 relative to the frame 105 while the apparatus 111 is in use.

The fastening means 111 can be configured to bias at least part of the cooling means 107 against the heat source 103 to maintain the cooling means 107 in thermal contact with the heat source 103. The fastening means 111 are configured to provide a biasing force that pushes the cooling means 107 against the heat source 103. This biases at least part of the cooling means 107 against the heat source 103 to maintain the cooling means 107 in thermal contact with the heat source 103 during use of the apparatus 101.

Biasing the cooling means 103 against the heat source 103 acts to reduce any gaps between the heat source 103 and the cooling means 107. For example, it can reduce any gaps that arise due to manufacturing tolerances or imperfections in the surfaces of the heat source 103 and the cooling means 107. Reducing any gaps minimizes, or substantially minimizes, the thickness of the layer of thermal interface material 109 that is used between the at least one heat source 103 and the cooling means 107.

In examples of the disclosure the fastening means 111 can comprise any suitable fastener such as spring screws, leaf springs or any other suitable types of fastener.

In some examples the fastening means 111 can be formed from a thermally conductive material such as aluminium or any other suitable material.

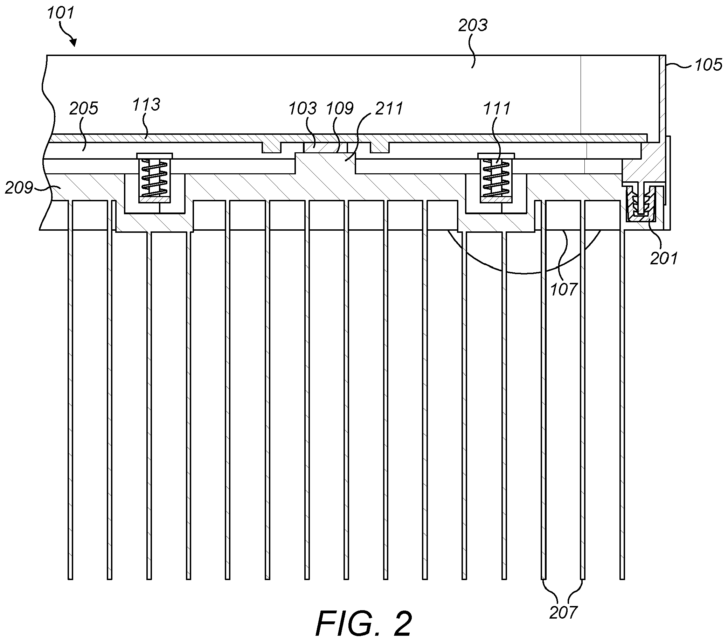

Fig. 2 shows a section of another example apparatus 101 according to examples of the disclosure.

This example apparatus 101 comprises a heat source 103 as shown in Fig. 1. In this example the heat source 103 comprises a system on a chip. The heat source 103 is provided on a PCB 113. Other types of heat sources 103 could be used in other examples of the disclosure. In the example of Fig. 2 one heat source 103 is shown. It is to be appreciated that in examples of the disclosure the apparatus 101 can comprise more than one heat source 103.

In the example of Fig. 2 the frame 105 comprises a first member 203 and a second member 205. The first member 203 is provided on a first side of the PCB 113 and the second member 205 is provided on a second side of the PCB 113. The first and second frame members 203, 205 can provide a chassis for the PCB 113. The first and second frame members 105 can provide structural rigidity for the PCB 113 and/or components of the apparatus 101 such as the cooling means 107.

In this example the second frame member 205 is provided on the same side of the PCB 113 as the heat source 103. Other configurations for the frame 105 and the frame member 203, 205 can be used in other examples of the disclosure.

The apparatus 101 also comprises a cooling means 107. In this example the cooling means 107 comprises a three-dimensional heat sink. The three-dimensional heat sink comprises a flat, or substantially flat, portion 209 and a plurality of structures 207 that extend out of the flat, or substantially flat, portion 209.

In this example the structures 207 that extend out of the flat, or substantially flat, portion 209 comprise a plurality of fins. The fins comprise thin structures with a large surface area that allows for efficient dissipation of heat. The fins can be configured to contact a coolant fluid as the coolant fluid flows past the fins. The coolant could be air or any other suitable coolant.

The plurality of fins are provided extending from the flat, or substantially flat, portion 209. The flat, or substantially flat, portion 209 has a first side and a second side. The plurality of fins extend from the first side while the second side faces the PCB 113 and the heat sources 103.

The second side of the flat, or substantially flat, portion 209 comprises one or more contact portions 211. In the example of Fig. 2 the contact portion 211 comprises a projection from the second side of the flat, or substantially flat, portion 209. The projection reduces the sizes of any gaps between the cooling means 107 and the heat source 103.

The contact portions 211 are configured to provide contact between the heat sources 103 on the PCB 113 and the cooling means 107. The contact portions 211 can be configured to thermally contact the heat sources 103 so as to enable heat to be transferred from the heat source 103 to the contact portion of the cooling means 107.

The cooling means 107 can be formed from a thermally conductive material. The conductive material could be a metal such as aluminium or any other suitable type of material.

The cooling means 107 is fastened to the frame 105 by one or more fastening means 111. In this example the fastening means 111 comprises one or more spring screws. Other types of fastening means 111 can be used in other examples of the disclosure.

In the example of Fig. 2 two spring screws are shown. It is to be appreciated that any number of spring screws or other types of fastening means 111 could be used in other examples of the disclosure.

In the example of Fig. 2 the fastening means 111 are used to fasten the cooling means 107 to the frame 105. In the example of Fig. 2 the fastening means 111 fasten the flat, or substantially flat, portion 209 of the cooling means 107 to the second member 205 of the frame 105. The fastening means 111 could be used to fasten different respective components of the cooling means 107 and frame 105 together in other examples of the disclosure.

The fastening means 111 is configured to bias the cooling means 107 against the heat source 103 to maintain the at least one cooling means 107 in thermal contact with the heat source 103. In the example of Fig. 2 the fastening means 111 acts to provide a bias force that pushes the contact portion 211 of the cooling means 107 towards the heat source 103. The biasing force acts to minimise, or substantially minimise, the gaps between the contact portion 107 of the cooling means 107 and the heat source 103.

A thermal interface material 109 is provided between the contact portion 107 of the cooling means 107 and the heat source 103. As the fastening means 111 biases the contact portion 107 of the cooling means 107 towards the heat source 103 this reduces the gap that is to be filled by the thermal interface material 109. This can minimise, or substantially minimise, the thickness of the thermal interface material 109 that is used to fill the gap. In some examples the thermal interface material 109 only needs to be thick enough to fill in scratches or other imperfections on the surfaces of the heat source 103 and the cooling means 107. In some examples the thermal interface material 109 could have a thickness that is less than a micrometre.

In the example of Fig. 2 the apparatus 101 also comprises a seal 201. The seal 201 can be provided around the edge of the apparatus 101. The seal 201 can extend around the edge of the apparatus 101 to provide ingress protection for the heat source 103 and/or other components of the apparatus 101. In the example shown in Fig. 2 the seal 201 is provided between the frame 105 and the cooling means 107.

In some examples the seal 201 can extend around a portion of the apparatus 101. For example, the seal 201 could extend around part of the frame 105 and/or part of the cooling means 107. In some examples different seals 201 could be provided for different parts of the apparatus 101. In some examples the seal 201 could extend around the entire perimeter of the apparatus 101. In other examples the seal 201 might just extend around part of the perimeter.

The seal 201 can be a flexible seal. The seal 201 can comprise a flexible material such as rubber or any other suitable material. The seal 201 can be flexible to allow for vertical movement of the seal 201. The vertical movement of the seal 201 allows for deformation or other bending of the seal 201 when the fastening means 111 provides a bias force and pushes the cooling means 107 against the heat source 103. This bias force can push the seal 201 against the frame 105 and cause the deformation or other bending of the seal 201. The seal 201 can be flexible to allow this deformation while still providing sufficient ingress protection for the apparatus 101.

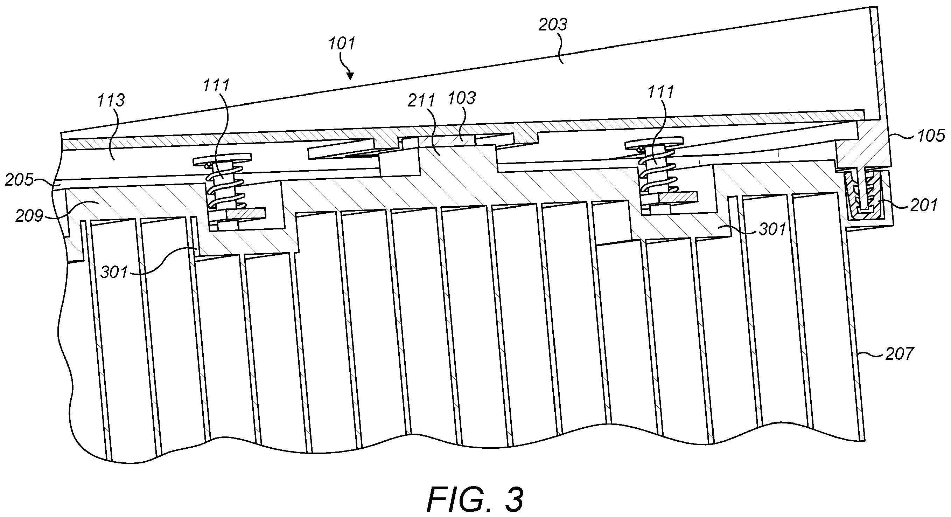

Fig. 3 shows another section of an apparatus 101 according to examples of the disclosure. The apparatus 101 could be the same apparatus 101 as shown in Fig. 2. Corresponding reference numerals are used for corresponding features.

The view of the apparatus 101 shown in Fig. 3 shows the cooling means 107 in more detail. The cooling means 107 comprises a three-dimensional heat sink. The three-dimensional heat sink comprises a flat, or substantially flat, portion 209 and a plurality of structures 207 that extend out of the flat, or substantially flat, portion 209.

In this example the structures 207 that extend out of the flat, or substantially flat, portion 209 comprise a plurality of fins. Only a portion of the fins is shown in Fig. 3. In the example of Fig. 3 the fins are arranged so that the surfaces of the fins are a parallel to each other. The fins are arranged so that the fins are evenly spaced. The sizes of gaps between adjacent fins is the same across the cooling means 107. Other arrangements of the fins could be used in other examples of the disclosure.

The flat, or substantially flat, portion 209 has a first side and a second side. The plurality of fins extend from the first side while the second side faces the PCB 113 and the heat sources 103.

The second side of the flat, or substantially flat, portion 209 comprises one or more contact portions 211. In the example of Fig. 2 the contact portion 211 comprises a projection from the second side of the flat, or substantially flat, portion 209. The projection reduces the sizes of any gaps between the cooling means 107 and the heat source 103. A layer of thermal interface material 109 can be provided between the heat source 103 and the contact portion 211. In the example shown in Fig. 3 the layer of thermal interface material 109 would be so thin compared to the heat source 103 and the contact portion 211 that it is not shown in Fig. 3.

The flat, or substantially flat, portion 209 also comprises one or more recesses 301. The fastening means 111 are provided within the recesses 301. The fastening means 111 fasten the flat, or substantially flat, portion 209 of the cooling means 107 to the frame 105. The fastening means 111 provides a bias force that pushes the cooling means towards the heat source 103 and reduces the thermal interface material 109 to be used.

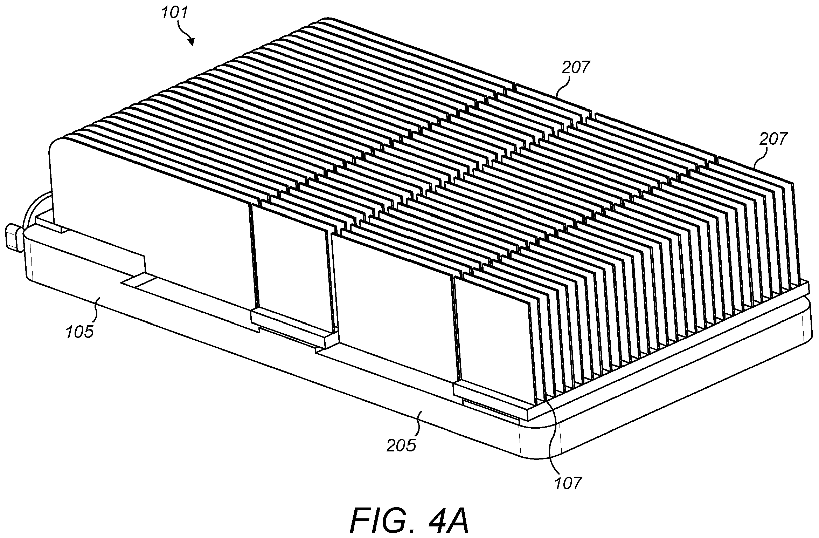

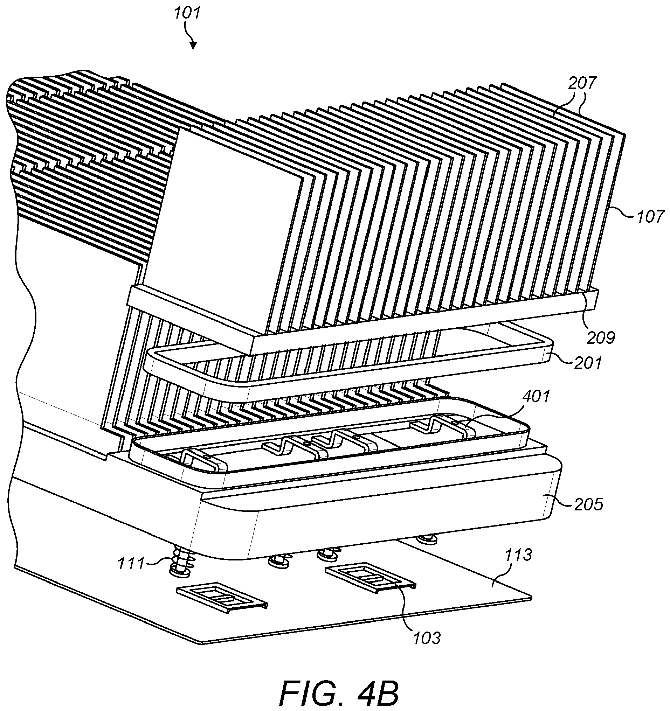

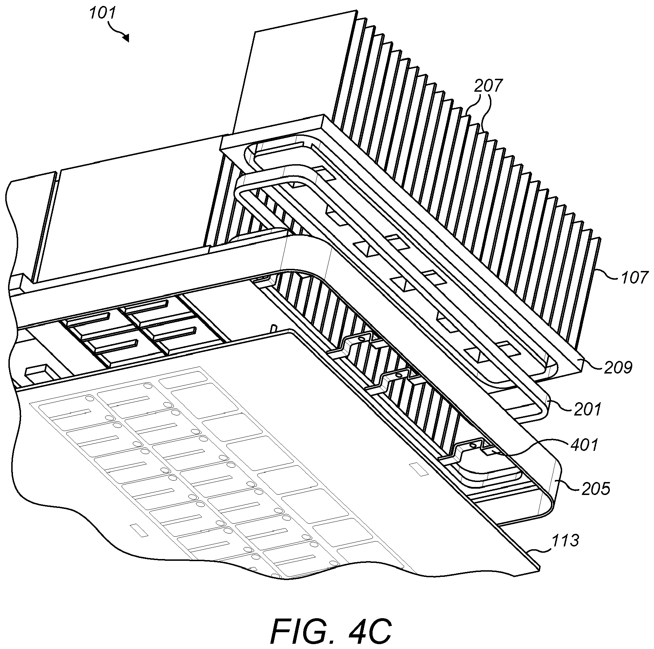

Figs. 4A to 4C show further views of an apparatus 101. Fig. 4A shows part of the frame 105 and the cooling means 107. Fig. 4B shows an exploded upper view of these components. Fig. 4C shows an exploded lower view of these components. The apparatus 101 could be the same as the apparatus 101 shown in Figs. 2 and 3. Corresponding reference numerals are used for corresponding features.

The view shown in Fig. 4A shows the cooling means 107 fastened to the frame 105. The PCB 113 and the heat source 103 are not shown in Fig. 4A. These would be underneath the cooling means 107.

The cooling means 107 is fastened to the frame 105 so that there are no gaps between the edges of the frame 105 and the edges of the cooling means 107. In this example the cooling means 107 comprises a plurality of structures 207. The structures 207 comprise a plurality of fins arranged in a parallel and evenly spaced configuration. Other types of structures 207 and arrangements of the structures 207 could be used in the cooling means 107 in other examples of the disclosure.

In the example of Figs. 4A to 4C the cooling means 107 comprises a plurality of different portions. The different portions of the cooling means 107 can be formed separately from each other. The different portions of the cooling means 107 can be fastened to the frame 105 independently of each other. The different portions of the cooling means 107 can each comprise a flat, or substantially flat portion 209 and a plurality of structures 207 extending from the flat, or substantially flat portion 209.

The exploded views of Fig. 4B And Fig. 4C show one of the portions of the cooling means 107 and the components underneath this portion of the cooling means 107. Fig. 4B shows the positions of two heat sources 103 on the PCB 113 and the positions of a plurality of fastening means 111. In this example four fastening means 111 are provided across the width of the PCB 113. Other numbers and arrangements of the fastening means 111 could be used in other examples of the disclosure.

In the example shown in Fig. 4B the frame member 205 comprises a plurality of recessed members 401. The recessed members 401 are configured to receive the fastening means 111. The recessed members 401 can be configured to be received in the recessed portions 301 of the flat, or substantially flat portion 209 of the cooling means 107. The recessed members 401 can be sized and shaped so as to fit snugly into. This enables the frame 105 to be fitted to the cooling means 107. The fastening means 111 can then be used to secure the cooling means 107 to the frame 105.

In the example shown in Figs. 4B and 4C a seal 201 is provided for the portion of the cooling means 107. The seal 201 extends around the edge of the part of the frame 105 to which the portion of the cooling means 107 is attached.

Only one seal 201 is shown in Figs. 4B and 4C. It is to be appreciated that the apparatus 101 could comprise more than one seal 201 in other examples of the disclosure. For example, the apparatus 101 can comprise a plurality of seals 201 where the different seals 201 are provided underneath different portions of the cooling means 107. The different seals 201 can therefore provide ingress protection for different parts of the apparatus 101 underneath the different portions of the cooling means 107.

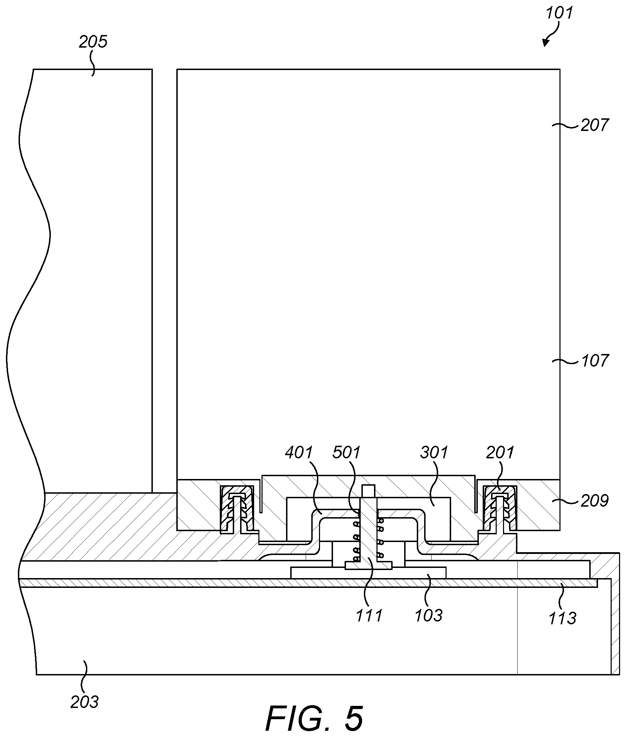

Fig. 5 shows a cross-sectional view of an apparatus 101. The apparatus 101 could be the same as the apparatus 101 shown in Figs. 2 to 4C. Corresponding reference numerals are used for corresponding features.

Fig. 5 shows how the fastening means 111 can be used to fasten the cooling means 107 to the frame 105. In the example shown in Fig. 5 the frame comprises a plurality of recessed members 401. The recessed members 401 fit into the recessed portions 301 of the flat, or substantially flat portion 209 of the cooling means 107.

The recessed members 401 comprise through holes 501. The fastening means 111 extend through the through holes 501 and secure the frame 105 to the recessed portions 301 of the flat, or substantially flat, portion 209 of the cooling means 107. This enables the fastening means 111 to be used to securely fasten the cooling means 107 to the frame 105.

In the example of Fig. 5 the fastening means 111 comprises a spring screw. Other types of fastening means 111 can be used in other examples of the disclosure. The fastening means 111 is configured to provide a biasing force that pushes the cooling means 107 towards the heat source 103 to provide for a good thermal interface between the cooling means 107 and the heat source 103.

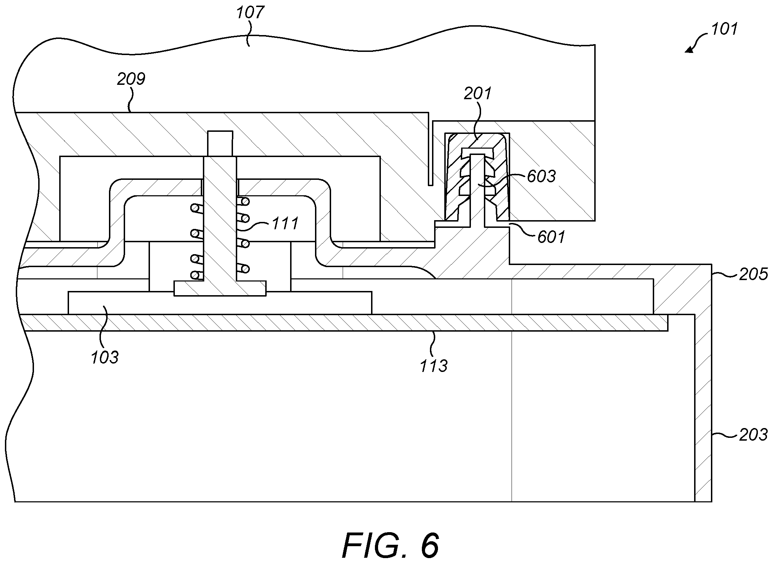

Fig. 6 shows another section of an apparatus 101. The apparatus 101 could be the same as the apparatus 101 shown in Figs. 2 to 5. Corresponding reference numerals are used for corresponding features.

In the example of Fig. 6 the seal 201 is provided over an edge member 603 of the frame 105. The edge member 603 provides a lip or rim around the edge of the frame 105 or around a portion of the frame 105.

The seal 201 comprises a flexible material that is provided overlaying the edge member 603. As shown in Fig. 6, a gap 601 can be provided between an outer edge of the seal 201 and the frame 105. This gap 601 allows for vertical deformation or other movement of the seal 201. This gap 601 allows the seal to be deformed when the fastening means 111 pushes the cooling means 107 towards the heat source 103.

This ensures that the seal 201 can provide sufficient ingress protection for different levels of biasing force applied by the fastening means 111.

Examples of the disclosure provide the technical benefit that the biasing of the cooling means 107 against the heat source 103 minimizes, or substantially minimizes, any gaps between the heat sources 103 and the cooling means. This reduces the thickness of the layer of thermal interface material 109 that is needed. This provides for a more efficient thermal interface and which can allow for more efficient functioning of the components that provide the heat source 103.

In this description the term coupled means operationally coupled. Any number or combination of intervening elements can exist between coupled components, including no intervening elements.

The above-described examples find application as enabling components of:
automotive systems; telecommunication systems; electronic systems including consumer electronic products; distributed computing systems; media systems for generating or rendering media content including audio, visual and audio visual content and mixed, mediated, virtual and/or augmented reality; personal systems including personal health systems or personal fitness systems; navigation systems; user interfaces also known as human machine interfaces; networks including cellular, non-cellular, and optical networks; ad-hoc networks; the internet; the internet of things; virtualized networks; and related software and services.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one..." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. An apparatus comprising:
at least one heat source;
at least part of a frame;
cooling means configured to enable cooling of the at least one heat source;
thermal interface material provided between the at least one heat source and at least part of the cooling means so as to provide a thermal interface between the at least one heat source and the cooling means; and
fastening means configured to fasten the cooling means to the at least part of a frame;
wherein, the fastening means are configured to bias at least part of the cooling means against the heat source to maintain the at least one cooling means in thermal contact with the heat source and to substantially minimize the thickness of the layer of thermal interface material between the at least one heat source and the cooling means.

2. An apparatus as claimed in claim 1 wherein the at least one heat source comprises one or more electronic components.

3. An apparatus as claimed in any preceding claim wherein the at least one heat source comprises a system on a chip.

4. An apparatus as claimed in any preceding claim wherein the frame is configured to provide structural rigidity to the cooling means.

5. An apparatus as claimed in any preceding claim wherein the fastening means are configured to bias at least part of the cooling means against the heat source to maintain the cooling means in thermal contact with the at least one heat source during use of the apparatus.

6. An apparatus as claimed in any preceding claim wherein the fastening means comprises any one or more of; spring screws, leaf springs.

7. An apparatus as claimed in any preceding claim wherein the thermal interface material is configured to provide a direct interface between the at least one heat source and the cooling means.

8. An apparatus as claimed in any preceding claim wherein the thermal interface material is provided to remove air gaps between the at least one heat source and the cooling means.

9. An apparatus as claimed in any preceding claim wherein the thermal interface material comprises a grease.

10. An apparatus as claimed in any preceding claim wherein the apparatus comprises a flexible seal provided around the edge of the apparatus.

11. An apparatus as claimed in claim 10 wherein the seal is flexible to allow for vertical movement of the seal.

12. An apparatus as claimed in any of claims 10 to 11 wherein the seal provides for ingress protection.

13. An apparatus as claimed in any preceding claim wherein the cooling means comprises one or more heat sinks.

14. An apparatus as claimed in any preceding claim wherein the cooling means is configured to enable heat from the heat source to be transferred to a coolant.

15. An apparatus as claimed in any preceding claim wherein the cooling means comprises a plurality of fins.
